# EUROPEAN PATENT APPLICATION

(11) **EP 2 506 292 A1**
(43) Date of publication of application: **03.10.2012**
(21) Application number: 10833311.3
(22) Date of filing: 26.11.2010
(51) Int. Cl.: H01L 21/28, H01L 21/336, H01L 27/28, H01L 29/786, H01L 33/02, H01L 51/05, H01L 51/42, H01L 51/50

(54) **PROCESS FOR PRODUCTION OF CONTACT STRUCTURE FOR ORGANIC SEMICONDUCTOR DEVICE, AND CONTACT STRUCTURE FOR ORGANIC SEMICONDUCTOR DEVICE**

(30) Priority: 26.11.2009 JP 2009268309
(71) Applicant: National Institute for Materials Science, Tsukuba-shi, Ibaraki 305-0047 (JP)
(72) Inventor: MINARI Takeo, Tsukuba-shi Ibaraki 305-0047 (JP); KUMATANI Akichika, Tsukuba-shi Ibaraki 305-0047 (JP); TSUKAGOSHI Kazuhito, Tsukuba-shi Ibaraki 305-0047 (JP)
(74) Representative: Isarpatent
(86) International application number: PCT/JP2010/071096
(87) International publication number: WO 2011/065465

(57) **Abstract**

A method of manufacturing a contact structure for organic semiconductor devices having excellent electrical characteristics and a contact structure of organic semiconductor devices are provided. To manufacture a contact on an organic semiconductor layer 3, a very thin film of several nm or thinner, for example, of an easily oxidizable metal is formed first, and this film is used as a charge-injection layer 4. On the charge-injection layer 4, a current-supply layer 5 is then formed using a conductive material such as a stable metal. The contact resistance for organic semiconductor devices can be decreased by simple processes and by using inexpensive materials.

## Description

### Technical Field

The present invention relates to a method of manufacturing a contact structure for organic semiconductor devices capable of decreasing the contact resistance between an organic semiconductor layer and electrodes in organic semiconductor devices such as organic transistors by an extremely simple process, and the contact structure for organic semiconductor devices.

### Background Art

It is known that compared with inorganic semiconductor devices, organic semiconductor devices such as organic transistors, organic light emitting diodes, organic photovoltaic cells, and organic memories have much larger contact resistance, which inhibits device operations. As contact materials for organic semiconductor devices, stable noble metals such as gold and platinum are generally used because of the stability of noble metals in the atmosphere of the air, and their relatively large work functions, which facilitate hole injection into p-type organic semiconductors such as pentacene and copper phtalocyanine. The work function values of gold and platinum are 5.1 eV and 5.6 eV, respectively.

However, since the manufacturing cost of conventional organic semiconductor devices using expensive noble metals is high, and despite use of such expensive materials as a contact, their contact resistance still remains high. To decrease the large contact resistance, insertion of acceptor-type molecules or a metal oxide layer into the interface between a contact layer and an organic semiconductor layer has been presented (Patent Reference 1, Non-patent References 1 to 3).

### Prior Technical Reference

### [Patent Reference]

Patent Reference 1: WO 2009/063859

### [Non-patent Reference]

Non-patent Reference 1: Applied Physics Letters, Vol. 84, p.1004, (2004), R. Schroeder, et al., "Improving organic transistor performance with Schottky contacts"
Non-patent Reference 2: Applied Physics Letters, Vol. 87, p.193508, (2005), C. W. Chu, et al., "High-performance organic thin-film transistors with metal oxide/metal bilayer electrode"
Non-patent Reference 3: Applied Physics Letters, Vol. 91, p.053508, (2007), T. Minari, et al., "Charge injection process in organic field-effect transistors"

### Summary of Invention

### Problems to be Solved by the Invention

As mentioned above, various attempts have been made to decrease the contact resistance of conventional organic semiconductor devices. However the use of acceptor-type molecules shows poor reproducibility and the deposition of metal oxide by oxide sputtering causes damage to an organic semiconductor layer. Thus a problem of contact resistance is still remained unsolved.

In view of the above problems, the present invention intends to decrease the contact resistance of organic semiconductor devices by a simple process, thereby providing a method of manufacturing a contact structure for organic semiconductor devices made of inexpensive materials and having excellent electrical property. This invention also presents the contact structure for organic semiconductor devices.

### Means for Solving the Problems

According to one aspect of the present invention, a method of manufacturing a contact structure for organic semiconductor devices, including a process of forming a charge-injection layer made of an easily oxidizable thin metal film, one surface of which contacting a current-supply layer whereas the other surface contacting an organic semiconductor layer, is provided. The charge injection layer can be formed between a process of forming an organic semiconductor layer and a process of forming a current-supply layer made of a conducting material, or between a process of forming a current-supply layer made of a metal and a process of forming an organic semiconductor layer.

The above structure allows the easily oxidizable metal thin film to be oxidized with oxygen under ambient atmosphere and thus turns into a native oxide film.

Oxygen can be supplied by exposing the devices to the air after the completion of all fabrication processes, or by exposing the metal thin film to the air when taking the metal thin film out from a treatment vessel for fabrication after the process of forming the charge-injection layer but before the completion of all processes.

A charge-injection layer can be formed after forming a organic semiconductor layer, and after that an current-supply layer can be formed on the charge-injection layer.

It is also possible to form a charge-injection layer on a current-supply layer, followed by a formation of a organic semiconductor layer, depending on the device structures.

A conductive material that becomes a current-supply layer can be formed by any conductive material such as metals, conductive metal oxides, and conductive organic materials.

As an easily oxidizable metal, the one having standard redox (oxidation-reduction) potential smaller than +0.5 V may be used.

The thickness of the charge-injection layer may be 5 nm or thinner.

As an easily oxidizable metal, any one of beryllium (Be), nickel (Ni), aluminum (Al), chromium (Cr), cobalt (Co), zinc (Zn), copper (Cu), and iron (Fe) may be used.

As an organic semiconductor layer, any one of π-conjugated aromatic compounds, chain compounds, organic pigments, and organic silicon compounds may be used.

As an organic semiconductor layer, any one of acene-series compounds including pentacene, perylene-series compounds, origothiophenes, polythiophenes, phthalocyanines including copper phthalocyanine, and porphyrins may be used.

As an organic semiconductor device, any one of organic transistors, organic light-emitting diodes, organic photovoltaic cells, and organic memories may be selected.

According to another aspect of the present invention, a contact structure for organic semiconductor devices including (a) and (b) shown below is provided:
(a) a conductive thin film, and
(b) a native oxide film of an easily oxidizable metal, one surface of which contacting an organic semiconductor layer and the other surface contacting the conductive thin film.

In the above structure, as the easily oxidizable metal, the one having oxidation-reduction potential smaller than +0.5 V may be used.

The thickness of the native oxide film may be 5 nm or thinner.

As the easily oxidizable metal, any one of beryllium (Be), nickel (Ni), aluminum (Al), chromium (Cr), cobalt (Co), zinc (Zn), copper (Cu), and iron (Fe) may be used.

As the organic semiconductor layer, any one of acene-series compounds including pentacene, perylene-series compounds, origothiophenes, polythiophenes, phthalocyanines including copper phthalocyanine, and porphyrins may be used.

As the conductive thin film, any one of metals, conductive metal oxides, and conductive organic materials may be used.

As the organic semiconductor device, any one of organic transistors, organic light-emitting diodes, organic photovoltaic cells, and organic memories may be selected.

### Effects of the Invention

According to the method of manufacturing a contact structure for organic semiconductor devices of the present invention, contact resistance can be decreased significantly without excessively complicating the organic semiconductor device manufacturing process and by using inexpensive and various materials.

According to the method of manufacturing a contact structure for organic semiconductor devices of the present invention, a simple structure wherein a thin film that is to become a charge-injection layer is inserted between an organic semiconductor layer and an electrode layer, which achieves significant reduction in contact resistance.

### Brief Description of Drawings

In the drawings:
FIG. 1 illustrates the device structure of an organic transistor presented by the present invention, wherein (A) is an outline perspective view, and (B) is a cross-sectional view of (A) along the line I-I;
FIG. 2 is an energy-level diagram illustrating the relation between the valence band of pentacene, a typical conventional organic semiconductor, and the work function of electrode metal;
FIG. 3 is a chart showing the drain-source current to gate voltage characteristics of an organic transistor using Cu, Al, and Au as a charge-injection layer in Example 1 and Comparative Example 1;
FIG. 4 is a chart showing the result of the transmission line method (TLM) analysis for evaluating the contact resistance of the organic transistor using Cu, Al, and Au as a charge-injection layer in Example 1 and Comparative Example 1;
FIG. 5 is a chart showing the contact resistance - gate voltage characteristics of the organic transistor using Cu, Al, and Au as a charge-injection layer in Example 1 and Comparative Example 1;
FIG. 6 is a chart showing the correlation between the contact resistance of the organic transistor using various charge-injection layers and the work function of the metal used for the charge-injection layer in Example 2 and Comparative Example 2;
FIG. 7 is a chart showing the correlation between the contact resistance of the organic transistor using various charge-injection layers and the oxidation-reduction potential of the metal used for the charge-injection layer in Example 2 and Comparative Example 2;
FIG. 8 is a chart showing the drain-source current to gate voltage characteristics of the organic transistors using Au, Cu, and Al as a charge-injection layer in Comparative Example 4 where the devices are fabricated and measured in vacuum and inert gas atmosphere without exposing to the atmosphere of the air;
FIG. 9 is a chart showing the relation between the work function of the metals used for the charge-injection layer and the contact resistance of the organic transistors in Comparative Example 4;
FIG. 10 is a chart showing the drain-source current to gate voltage characteristics of the organic transistors fabricated in vacuum and inert gas atmosphere and then exposed to the atmosphere of the air to form a charge-injection layer using each of the following metals: Cu, Al, and Au in Example 3 and Comparative Example 3;
FIG. 11 is an energy-level diagram showing the relation between the valence band of pentacene and the work function of the oxide of the charge-injection layer in the contact structure of the present invention;
FIG. 12 is an energy-level diagram illustrating the process wherein carriers are newly generated at the contact interface as a result of charge transfer between the oxide and pentacene in the contact structure of the present invention; and
FIG. 13 is a chart showing the relation between the contact resistance of the organic transistor using Al as the charge-injection layer and the film thickness of the charge-injection layer in Example 4.

### Description of Codes

- 1: Heavily doped silicon wafer
- 2: Silicon oxide film
- 3: Organic semiconductor layer
- 4: Charge-injection layer
- 5: Current-supply layer
- 6: Electrode
- 10: Organic transistor

### Modes for Carrying Out the Invention

The embodiment of the present invention will hereinafter be described in detail by referring to the drawings.

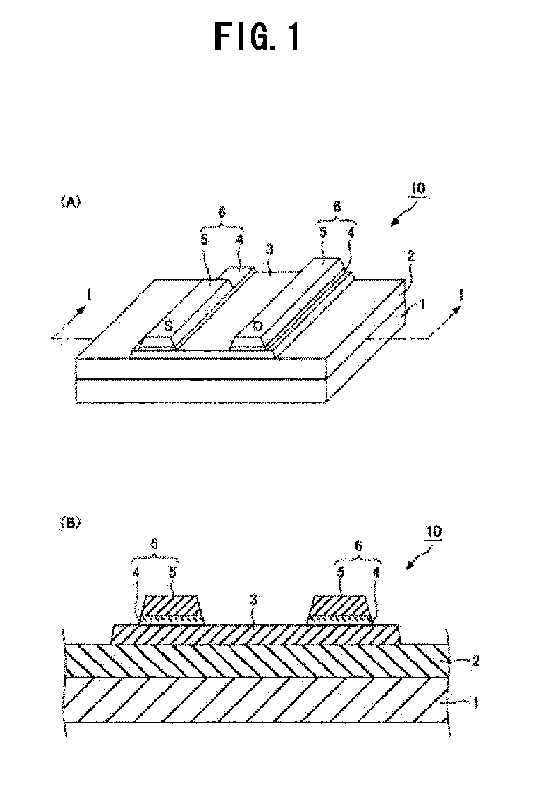

FIG. 1 illustrates the device structure of an organic transistor 10 according to the embodiment of the present invention, where (A) is an outline perspective view and (B) is a cross-sectional view of (A) along the line I-I.
As shown in FIG. 1, an organic transistor 10 has a silicon oxide film 2 formed on a heavily doped silicon wafer 1, and an organic semiconductor layer 3, which serves as a channel, is formed on the silicon oxide film 2. In the contact structure of the organic transistor 10 according to the present invention, a charge-injection layer 4 is inserted into the contact interface between the organic semiconductor layer 3 and a current-supply layer 5. Namely, one surface of the charge-injection layer 4 contacts the organic semiconductor layer 3, and the other surface contacts a conductive thin film that serves as the current-supply layer 5. The charge-injection layer 4 is made of a native oxide film of an easily oxidizable metal. Electrodes 6, which consist of the current-supply layer 5 and the charge-injecting layer 4, operate as a source electrode (S) and drain electrode (D) of the organic transistor 10. The heavily doped silicon wafer 1 becomes the gate of the organic transistor 10.

According to the contact structure of the organic transistor 10 of the present invention, the charge-injection layer 4 contacting the organic semiconductor layer 3 is included as part of the electrode 6. As a result, the contact resistance between the organic semiconductor layer 3 and the electrodes 6 can be decreased significantly.

The features of the embodiment of the present invention are that the charge-injection layer 4 is made of an easily oxidizable metal and it is naturally oxidized under air, namely a metal element having small oxidation-reduction potential, and that its film thickness is several nm or thinner. This film thickness varies within a range from 0.5 nm to 5 nm, for example. Since such metal elements are easily oxidized in the air atmosphere, they have been considered inappropriate as contact materials for p-type organic semiconductors. The present invention improves charge injection into organic semiconductors by inserting a thin film of such metal elements into the interface between a electrode and a p-type organic semiconductor as a charge-injection layer 4. A thin film of an easily oxidizable metal is spontaneously oxidized due to the effect of oxygen in the air and turns into a metal oxide of low valence band energy level, namely having a large work function. Consequently, the contact resistance of organic semiconductor devices such as organic transistor 10 can be decreased significantly, compared to the conventional metal electrodes.

The present invention uses oxidation reaction of charge-injection layer 4 due to oxygen in the air, etc. Any metal can be used as the charge-injection layer 4 if the material is easily oxidizable and generates a stable metal oxide. As metals to be used for the charge-injection layer 4, those having oxidation-reduction potential lower than +0.5 V are applicable, but those having oxidation-reduction potential lower than 0 V is desirable, and those having oxidation-reduction potential lower than -1.5 V is more preferable.

In the process of manufacturing an organic semiconductor device 10, even if a film of an easily oxidizable metal is formed in vacuum or in an inert gas atmosphere where oxygen does not exist, this metal film is exposed to the atmosphere when it is taken out of a vacuum vessel temporarily and changes into a spontaneously oxidized film. Even if the inert atmosphere where oxygen does not exist is maintained to the next film formation process, this metal film changes into a native oxide film as a result of subsequent exposure to the atmosphere of the air.

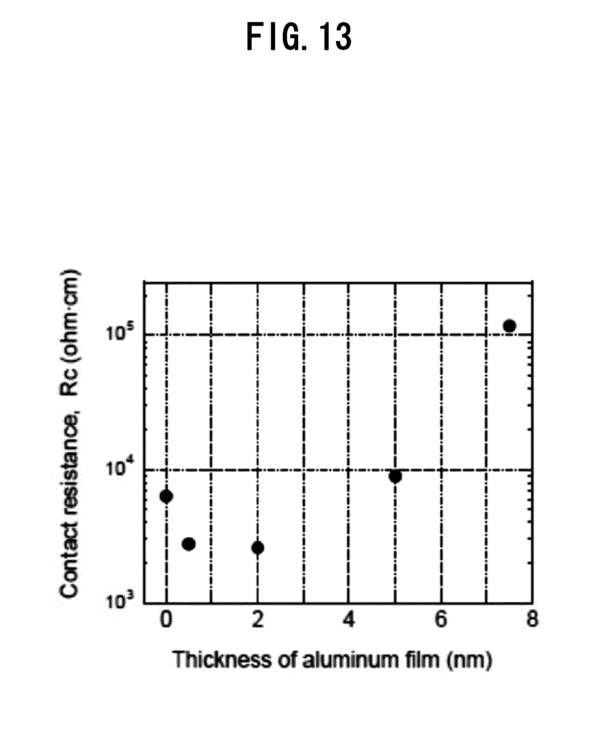

When a charge-injection layer 4 using a metal whose oxide becomes an insulating material such as aluminum (Al) is formed, the thickness of the charge-injection layer 4 preferably is 5 nm or less as described later by referring to FIG. 13, and more preferably, 2 nm or less. There is an upper limit in the thickness of the charge-injection layer 4 for the following reason: when the insulating metal oxide film at the interface between the electrodes 6 and the organic semiconductor layer 3 is too thick, electrical resistance of the charge-injection layer 4 increases, thus inhibiting charge injection on the contrary.
Meanwhile, when a charge-injection layer 4 using a metal whose oxide is conductive such as copper (Cu), even if the film thickness is 5 nm or thicker, the charge injection is not inhibited. Even in a case a thicker charge-injection layer 4 is used, sufficient effect for decreasing contact resistance can be obtained, provided that the film thickness of the charge-injection layer 4 is 5 nm at the maximum.

When a charge-injection layer 4 can be formed on the surface of the organic semiconductor layer 3 or conductive current-supply layer 5, its thickness can be reduced further. As the easily oxidizable metal which can be used as the charge-injection layer 4, for instance, aluminum (Al) and copper (Cu), beryllium (Be), nickel (Ni), chromium (Cr), cobalt (Co), zinc (Zn), and iron (Fe) are available.

The conductive current-supply layer 5 is formed on the surface of the charge-injection layer 4 not contacting the organic semiconductor layer 3 to supply current through the charge-injection layer 4. As examples of the materials for this current-supply layer 5, metals difficult to be oxidized such as gold (Au) and platinum (Pt), conductive metal oxides, and conductive organic materials such as conductive polymers may be used. Note that conductive materials applicable to the current-supply layer 5 are not limited to those listed above.

In the following Examples, pentacene is used as a typical organic semiconductor. However, usable organic semiconductor is not limited to pentacene because the present invention has effect on all the p-type organic semiconductors. Currently known organic semiconductors include π-conjugated aromatic compounds, chain compounds, organic pigments, and organic silicon compounds etc. More specifically, the organic semiconductors include acene compounds, perylene compounds, origothiophenes, polythiophenes, polythiophenes, and phthalocyanines. Acene compounds include pentacene, pentacene derivatives, anthracene, and anthracene derivatives. The organic semiconductors may be origothiophenes, polythiophenes, and derivatives of phthalocyanines. Phthalocyanines include copper phthalocyanine and zinc phthalocyanine. Note that organic semiconductors applicable to the present invention are not limited to those listed above.

The methods of forming the organic semiconductor layer 3 include vacuum deposition and solution process, but the present invention is applicable to the organic semiconductor layer 3 formed by any other methods.

The effect of the contact structure for organic semiconductor devices according to the present invention originates from the interface between the organic semiconductor layer 3 and the electrode 6, which consist of a charge-injection layer 4 and a current-supply layer 5. Consequently, when the electrode 6 consisting of a charge-injection layer 4 and a current-supply layer 5 is formed on the organic semiconductor layer 3, any device structures can be adopted for other parts. For example, the present invention is applied to the organic transistor 10 in the following Examples simply because it is convenient to measure the contact resistance. The present invention is also applicable to the contact structure of any other organic semiconductor devices such as organic light-emitting diodes, organic photovoltaic cells, and organic memories.

With the organic transistor 10 as shown below, electrodes 6 are formed on the already-formed organic semiconductor layer 3. However, it is typical that the organic semiconductor layer 3 is formed after the electrode 6 is formed for the devices such as an organic light-emitting diode, an organic photovoltaic cell, an organic memory, a bottom-contact-type organic transistors in which electrode is formed under the organic semiconductor layer 3. In such cases also, the present invention is applicable through the process of forming the charge-injection layer 4 on the current-supply layer 5 first to use them as the electrode 6, and then forming a thin film of an organic semiconductor layer 3.

As an example, the case where the present invention is applied to an organic light-emitting diode is described below.
Transparent oxide electrodes are formed as a current-supply layer 5, and on this layer, an easily oxidizable metal thin film is formed as a charge-injection layer 4 before an organic semiconductor layer 3 is formed. The current-supply layer 5 becomes an anode. Then the several layers of the organic semiconductor layer 3 are formed on the charge-injection layer 4, and furthermore a cathode is formed to manufacture an organic light-emitting diode. In this case, by exposing the completed device to the atmosphere of the air, the charge-injection layer 4 changes into an oxide due to native oxidation, thereby improving the efficiency of charge injection into the organic semiconductor layer 3. Oxidation of the charge-injection layer 4 may be performed before the organic semiconductor layers 3 are formed. In other words, oxidation of the charge-injection layer 4 may be performed after the process of forming a metal thin film that becomes a charge-injection layer 4 and before the formation of the organic semiconductor layer 3.

### Example

### [Example 1]

As Example 1, an organic transistor 10 as shown in FIG. 1 was fabricated. The electrode 6 was fabricated to be in a double-layered structure having a charge-injection layer 4 and a current-supply layer 5. In this case, a 200-nm silicon oxide film 2 was formed on the surface of a heavily doped silicon wafer 1 to be used as a substrate. Here the heavily doped silicon wafer 1 is used as a gate electrode, whereas the silicon oxide film 2 acts as a gate insulating layer. After the surface of the silicon oxide film 2 was treated with phenethyltrichlorosilane, pentacene was formed by vacuum deposition under the condition of film thickness of 40 nm as an organic semiconductor layer 3. This electrode 6 has a double-layered structure with Cu deposited in thickness of 2 nm on the organic semiconductor layer 3 as the charge-injection layer 4, and gold (Au) is deposited in thickness of 38 nm as the current-supply layer 5 on the charge-injection layer 4. One of these two electrodes 6 is used as a source electrode S, whereas the other is used as a drain electrode D. When the manufactured device is exposed to the atmosphere of the air, the charge-injection layer 5 is oxidized due to oxygen in the atmosphere of the air, and changed into a native oxide film. In addition, the organic transistor 10 in which charge-injection layer 4 made of Al instead of Cu was also fabricated.

### [Comparative Example 1]

As Comparative Example 1, the organic transistor 10 having the same structure as Example 1 but gold (Au) was used as the material of the charge-injection layer 4 was manufactured.

### [Comparison between Example 1 and Comparative Example 1]

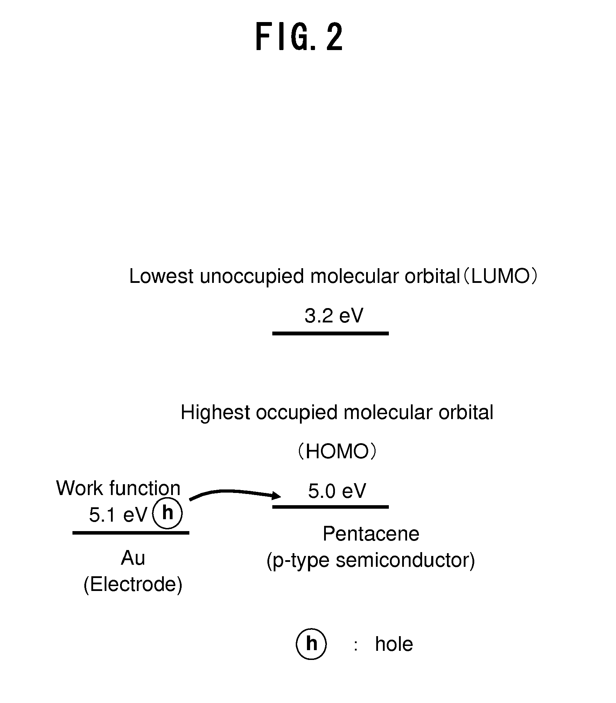

FIG. 2 is an energy-level diagram showing the relation between the valance band of pentacene, i.e. a typical p-type organic semiconductor, and the work function of the electrode metal.

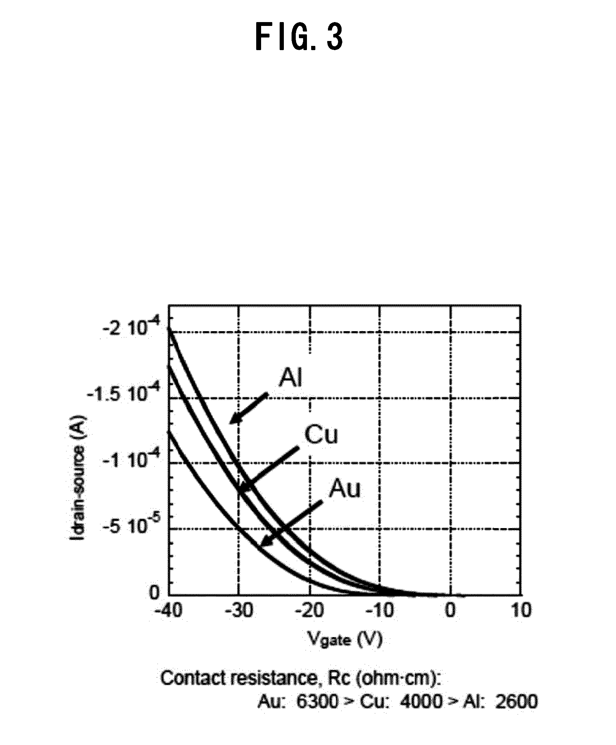

As shown in FIG. 2, for p-type organic semiconductors such as pentacene, metals having a large work function are generally considered to be advantageous for hole injection. Since the metals used for charge-injection layer 4, namely Au, Cu, and Al have work function of 5.1 eV, 4.6 eV, and 4.28 eV, respectively, their contact resistance was expected to decrease in the following order: Au, Cu, Al. Practically, however, as shown in FIG. 3, the current value increased in the following order: Al, Cu, Au.

FIG. 3 is a chart showing the drain-source current to gate voltage characteristics of the organic transistor 10 using Cu, Al, and Au as a charge-injection layer 4 in Example 1 and Comparative Example 1. Although FIG. 3 itself is a chart showing the relation between the gate voltage and the drain-source current of the organic transistor 10, the measurement results shown in this chart indicate that the device contact resistance of Al in Example 1 is the lowest, followed by Cu in Example 1 and then by Au in Comparative Example 1, which is the highest.

Incidentally, the contact resistance of the organic transistor 10 can be generally obtained using a method called the transmission line method (TLM). Specifically, the on resistance in the linear region is plotted on the Y-axis, and the channel length is plotted on the X-axis. The on resistance in the linear region is obtained when the drain voltage of the organic transistor 10 is maintained constant at a value smaller than the gate voltage. Then, the Y-intercept of the plot is calculated as the contact resistance.

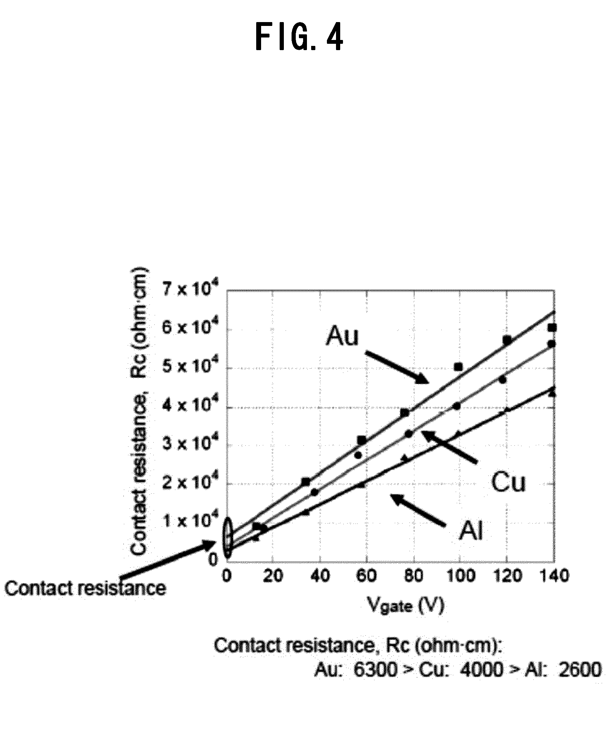

FIG. 4 shows the result of measurement conducted using this TLM method. This method is known to those skilled in the art (Non-patent Reference 3).
FIG. 4 is a chart (TLM) showing the result of measurement conducted to obtain the contact resistance of the organic transistor 10 using Cu, Al, and Au as the charge injection layer 4 in Example 1 and Comparative Example 3.
As is apparent from FIG. 4, the contact resistance of Al and Cu in Example 1 and that of Au in Comparative Example 1 were measured to be 2600 Ω·cm, 4000 Ω·cm, and 6300 Ω·cm, respectively with Al exhibiting the lowest contact resistance, followed by Cu, and then by Au, which exhibited the highest contact resistance.

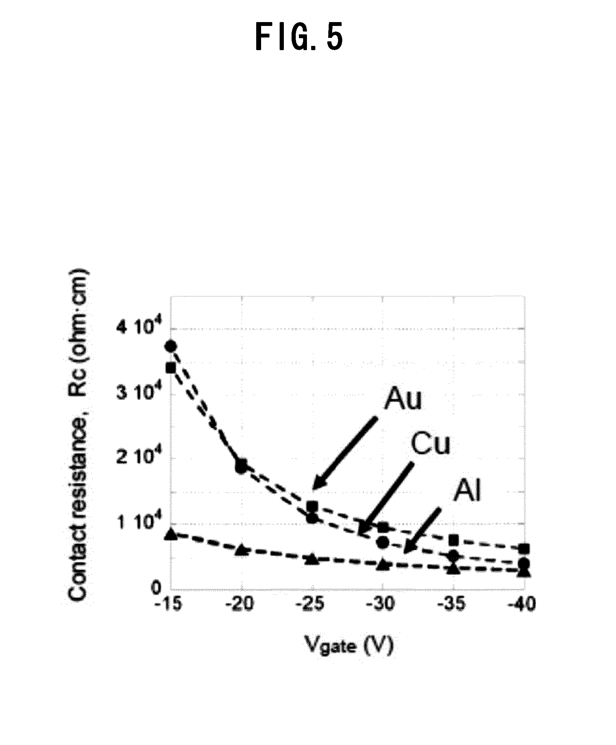

FIG. 5 is a chart showing the contact resistance-gate voltage characteristics of the organic transistor 10 using Cu, Al, and Au as the charge-injection layer 4 in Example 1 and Comparative Example 1.
As shown in FIG. 5, from the relation between contact resistance and gate voltage obtained by the TLM, the contact resistance value of Al was measured to be the lowest, followed by Cu, and then by Au, which exhibited the highest value. In the following Examples and Comparative Examples also, the contact resistance was similarly obtained by the TLM.

### [Example 2]

The organic transistors 10 in Comparative Example 2 were manufactured in the same manner as Example 1, here Cu, Fe, Co, Be, Ni, Zn, Al, and Cr were used as the charge-injection layer 4, respectively.

### [Comparative Example 2]

For a comparison purpose, organic transistors in the same structure as Example 1 but having a double-layer electrode structure wherein a charge-injection layer 4 was respectively made of Au, Ag, and Pd were manufactured as Comparative Example 2.

### [Comparison between Example 2 and Comparative Example 2]

The contact resistance of the organic transistors 10 manufactured in Example 2 and Comparative Example 2 was evaluated.

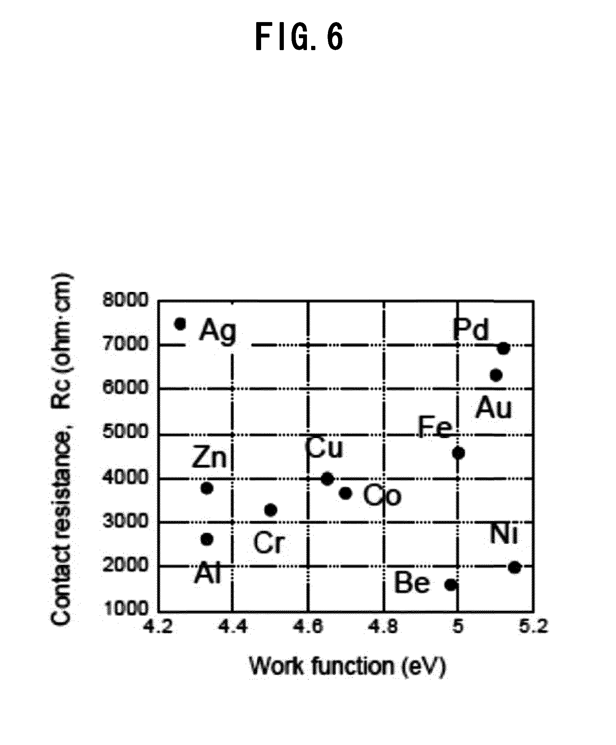

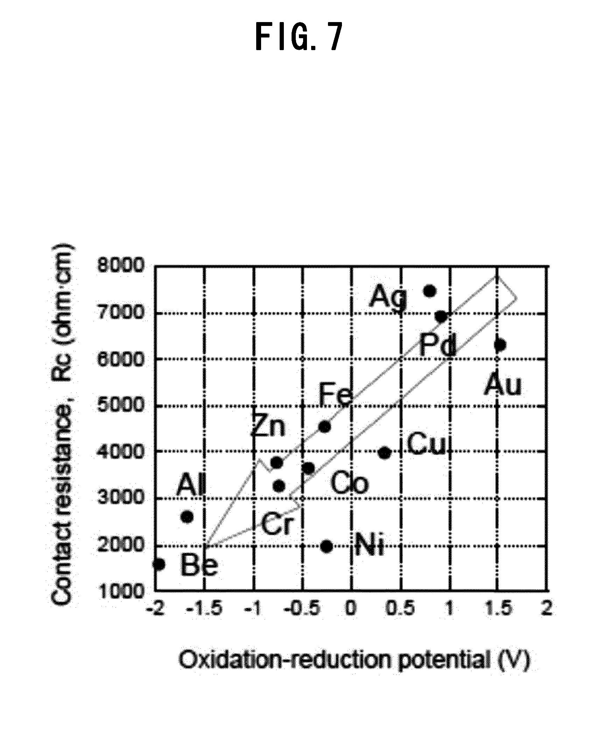

FIG. 6 is a chart showing the correlation between the contact resistance of the organic transistors 10 using various charge-injection layers 4 and the work function of the metals used for the charge-injection layers 4 in Example 2 and Comparative Example 2. FIG. 7 is a chart showing the correlation between the contact resistance of the organic transistors 10 using various charge-injection layers 4 and the oxidation-reduction potential of the metals used for the charge-injection layers 4 in Example 2 and Comparative Example 2.
As shown in FIG. 6, practically no correlation was found between the contact resistance and the work function of the metal element deposited on the organic semiconductor 3 as a charge-injection layer 4.
Meanwhile, as shown in FIG. 7, good correlation was found between the contact resistance and the oxidation-reduction potential of metal elements used as the charge-injection layer 4. From the above, the work function of the charge-injection layer 4 is not assumed to be dominant on the contact resistance, whereas the oxidation-reduction potential of the charge-injection layer 4 is assumed to have significant effect on the contact resistance. This oxidation-reduction potential is an index exhibiting the susceptibility of metals to oxidation, and the lower the oxidation-reduction potential of metals is, the more easily the metals are to be oxidized in the atmosphere of the air.

### [Example 3]

As Example 3, the organic transistors in the same structure as Example 1 but having a structure of double-layer electrode 6 wherein a charge-injection layer 4 was made of Cu and Al, respectively were manufactured. By manufacturing the organic transistors 10 using a vacuum deposition system and within a globe box whose inside is maintained in an inert gas atmosphere, the organic transistor 10 was prevented from being exposed to the atmosphere of the air during the entire device manufacturing process. In other words, the treatment was conducted in an atmosphere where oxygen did not exist from beginning to end. Then the completed organic transistor 10 having a contact structure was taken out into the atmosphere of the air and left for four hours, and their electrical characteristics were measured.

### [Comparative Example 3]

As Comparative Example 3, the organic transistor having the same double-layer electrodes structure as Example 3 but having a charge-injection layer 4 made of Au was manufactured by following the same process as Example 3 without exposure to the atmosphere of the air. Similar to Example 3, the completed organic transistor having a contact structure was then taken out into the atmosphere of the air and left for four hours, and its electrical characteristics were measured.

### [Comparative Example 4]

As Comparative Example 4, organic transistors in the same structure as Example 1 but having a double-layer electrodes structure wherein a charge-injection layer 4 was made of Au, Cu, Be, Ni, and Al, respectively were manufactured. As manufacturing conditions, the entire manufacturing was performed using a vacuum deposition system and a globe box, whose inside is kept by inert gas atmosphere similar to Example 3 and Comparative Example 3. Electrical characteristics were measured while this atmosphere was maintained. In other words, manufacture and electrical characteristics measurement of the organic transistors 10 in double-layer electrode structure were performed without exposing the relevant devices to oxygen even once.

### [Comparison between Example 3 and Comparative Examples 3 and 4]

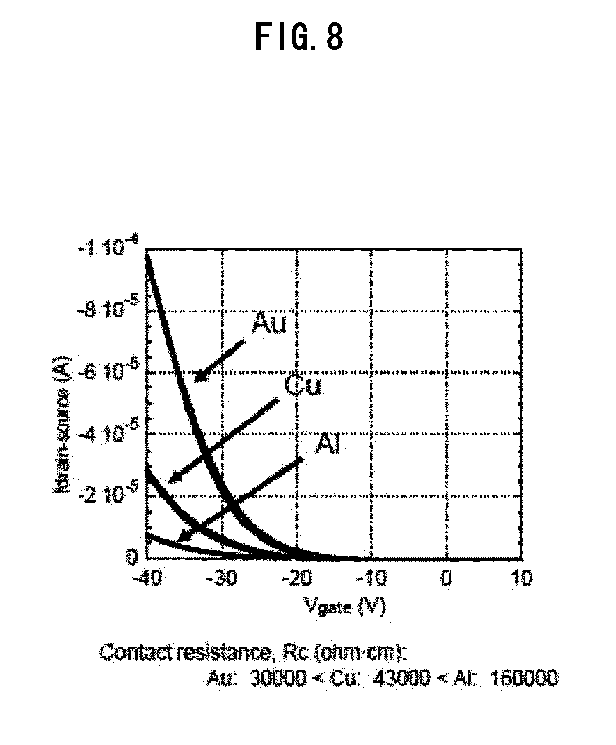

FIG. 8 is a chart showing the drain-source current to gate voltage characteristics of the organic transistors using Au, Cu, and Al as a charge-injection layer 4 in Comparative Example 4, which were manufactured in vacuum and inert gas atmospheres and these electrical characteristics were measured without exposing the devices to the atmosphere of the air.
As shown in FIG. 8, when the devices were kept in the inert atmosphere from the beginning of manufacturing process to the end of measurement without exposing to air, the contact resistance of Au was the lowest whereas that of Al was the highest. Namely the drain current of Au was the largest whereas the drain current of Al was the smallest, meaning that the effect of the charge-injection layer 4 on reduction in contact resistance was not obtained.

Furthermore, contact resistance was evaluated from the results of measurement of all the organic transistors manufactured in Comparative Example 4. Namely organic transistors having a double-layer electrode structure using Au, Cu, Be, Ni, and Al, respectively as the charge-injection layer 4.

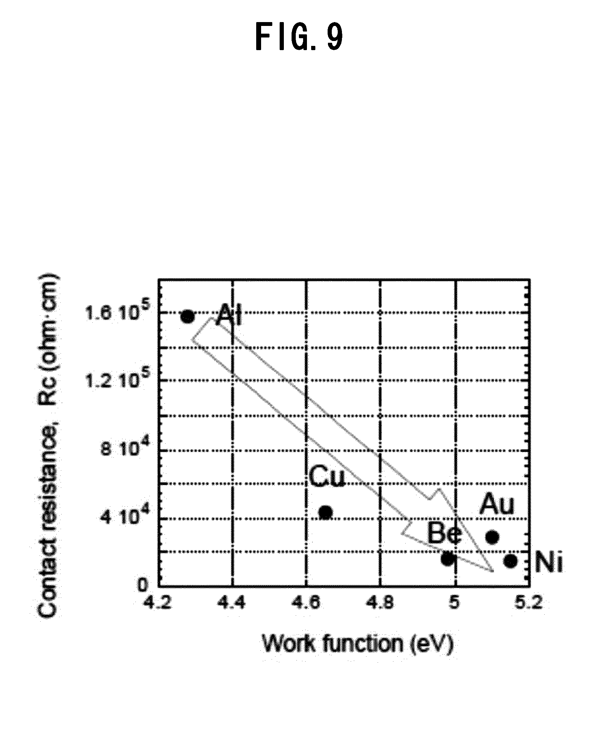

FIG. 9 is a chart showing the relation between the work function of the metals used for the charge-injection layer 4 and the contact of the organic transistor in Comparative Example 4. As described above, the manufacture of the organic transistors in Comparative Example 4 were performed in vacuum and inert gas atmospheres, and electrical characteristics were measured without exposing the transistors to the atmosphere of the air.
As shown in the distribution chart in FIG. 9, correlation was found between the contact resistance and the work function of the metal deposited for the charge-injection layer 4.

Furthermore, the measurement result of the contact resistance of the organic transistors 10 using Cu and Al as the charge-injection layer 4, of those manufactured in Example 3, and of the organic transistors 10 manufactured in Comparative Example 3 were studied. In other words, the contact resistance was obtained from electrical characteristics of the organic transistors 10 that were manufactured in vacuum and inert gas atmosphere, taken out into the atmosphere of the air and left for four hours.

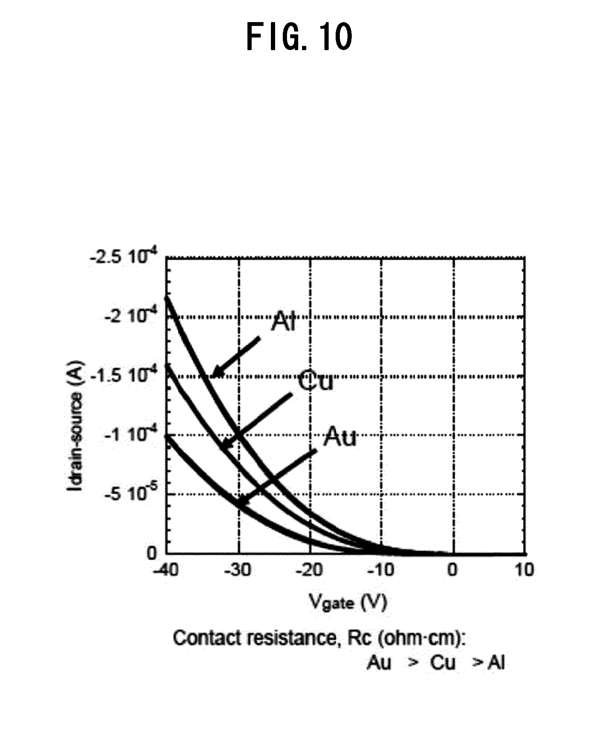

FIG. 10 is a chart showing the drain-source current to gate voltage characteristics of the organic transistors 10 manufactured in vacuum and inert gas atmospheres and then exposed to the atmosphere of the air to form the charge-injection layer 4 using each of Cu, Al, and Au metals in Example 3 and Comparative Example 3.
As shown in FIG. 10, the drain-source current to gate voltage characteristics were found to be mostly identical to the chart in FIG. 3, meaning that contact resistance has decreased. It was found that the drain-source current of the organic transistors 10 using Cu and Al as the charge-injection layer 4 in Example 3 were found to be larger than that of the organic transistor using Au as the charge-injection layer 4 in Comparative Example 3. Namely, the contact resistance of the organic transistors 10 in Example 3 was observed to be smaller than that of the organic transistor in Comparative Example 3.

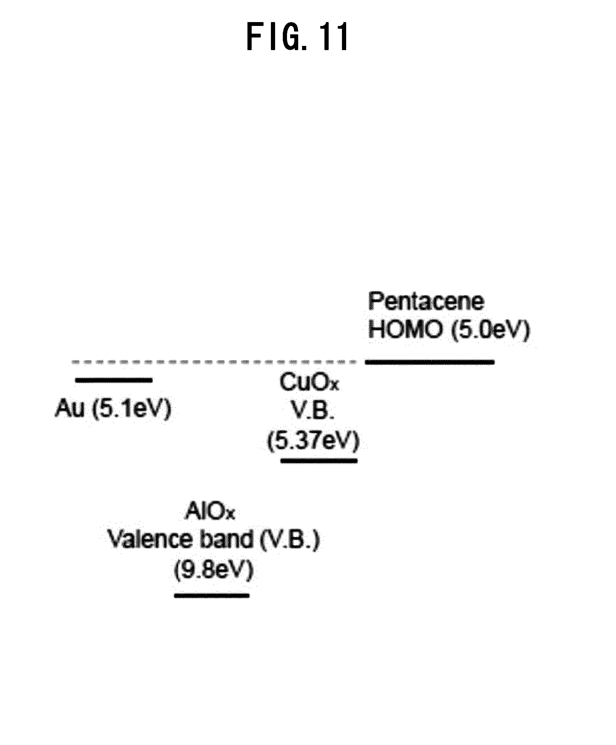

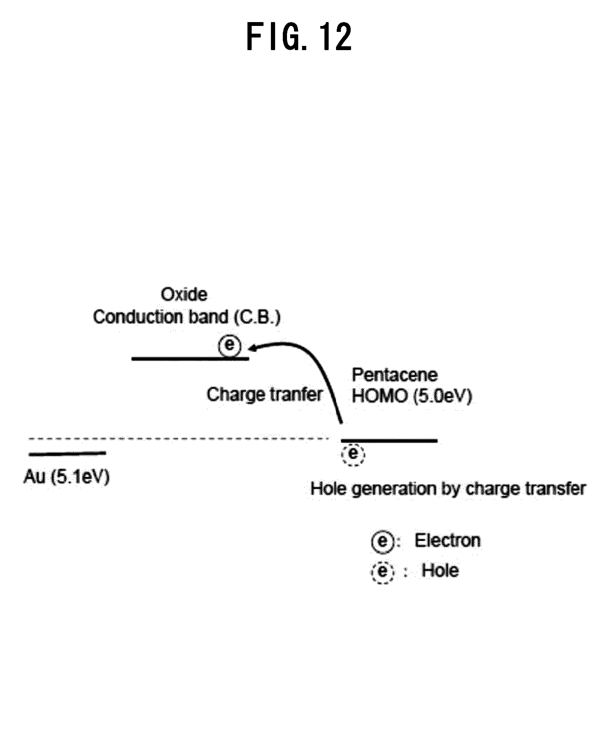

The contact resistance decreasing effect was achieved by providing a charge-injection layer 4 made of easily oxidizable metals whose oxidation-reduction potential is less than +0.5 V such as Cu and Al in Example 3, which indicates that the reduction in contact resistance was caused by oxidation reaction of the charge-injection layer 4 due to oxygen in the atmosphere of the air. As a mechanism how oxidation of the charge-injection layer 4 decreases contact resistance, the following two are assumed. The mechanisms will be described by referring to FIG. 11 and FIG. 12.
FIG. 11 is an energy-level diagram showing the relation between the valence band of pentacene and the work function of the oxide of the charge-injection layer 4 in the contact structure of the present invention.
Firstly, as shown in FIG. 11, the charge-injection layer 4 was oxidized and changed into a metal oxide having a large work function. As a result, charge injection from the electrodes 6 to the organic semiconductor was facilitated, and thereby the contact resistance of the organic transistor 10 decreased.
FIG. 12 is an energy-level diagram illustrating the process wherein carriers are newly generated at the contact interface as a result of charge transfer that occurs between the oxide and pentacene in the contact structure of the present invention.
Secondly, as shown in FIG. 12, charge transfer occurred between the oxide of the easily oxidizable metal forming the charge-injection layer 4 and pentacene, and as a result carriers were newly generated on the contact interface and thus the contact resistance decreased.

### [Example 4]

In Example 4, Al was used as the metal for the charge-injection layer 4 in Example 1, and the contact resistance was measured with the thickness of the deposition layer varied. FIG. 13 shows the measurement results. FIG. 13 is a chart showing the relation between the contact resistance of the organic transistor 10 using Al as the charge-injection layer 4 and film thickness of the charge-injection layer 4 in Example 4.
As shown in FIG. 13, when the film thickness of the charge-injection layer 4 exceeds 5 nm, the contact resistance is apparently larger than the case where this film is not provided, namely when the film thickness is 0 nm. Since AlOₓ, which is an oxide of Al, is an insulating material, the resistance of the charge-injection layer 4 itself is assumed to become larger than the decrease in contact resistance achieved by installation of the charge-injection layer 4, when the thickness of the Al charge-injection layer exceeds 5 nm. Consequently, it is desirable that the film thickness be 5 nm or thinner. Since the thickness of native oxide film of Al in the atmosphere of the air exceeds 5 nm, when an Al film is formed on the organic semiconductor layer 3 in thickness exceeding 5 nm, the contact resistance including the resistance of the charge-injection layer 4 increases on the contrary. When a thickness of native oxide film of metal, which has an insulating property, does not reach to decrease the net contact resistance to be offset, the problem as shown in FIG. 13, when the film thickness exceeds 5 nm, does not occur. Or, when the oxide is a conductive material also, the problem resulting from increased metal layer thickness as described above does not occur.

As shown in FIG. 13, when the film thickness decreased from 5 nm to 2 nm, the contact resistance was measured to be significantly lower than that of a case where the film thickness was 0. When the film thickness becomes thinner than 2 nm, the contact resistance seems to increase slightly. The reason for this is assumed to be as follows: when the film thickness is less than 2 nm, the film may not uniformly cover the organic semiconductor layer 3, and consequently, the effect of contact resistance reduction is limited. As apparent from the mechanism of decrease in contact resistance, the decrease in contact resistance will become more apparent by decreasing the film thickness to 2 nm or thinner, provided that a good film could be formed.

Table 1 summarizes the materials of each layer and oxidation treatment of the charge-injection layer of the organic transistors in Examples 1 to 4 and Comparative Example 1 to 4 described above.

**[Table 1]**

| | Organic semiconductor layer | Charge-injection layer | Current-supply layer | Oxidation treatment of charge-injection layer |
|---|---|---|---|---|
| Ex. 1 | Pentacene | Cu, Al | Au | Natural oxidation in the atmosphere of the air |
| Ex. 2 | | Cu, Fe, Co, Be, Ni, Zn, Al, Cr | Au | Same as Ex. 1 |
| Ex. 3 | | Cu, Al | Au | Left in the atmosphere of the air for 4 hours |
| Ex. 4 | | Al | Au | Same as Ex. 1 |
| Com. Ex. 1 | Pentacene | Au | Au | Same as Ex. 1 |
| Com. Ex. 2 | | Au, Ag, Pd | Au | Same as Ex. 1 |
| Com. Ex. 3 | | Au | Au | Left in the atmosphere of the air for 4 hours |
| Com. Ex. 4 | | Au, Cu, Be, Ni, Al, Cr | Au | No oxidation treatment |

### Industrial Applicability

According to the present invention, large contact resistance, which has been a problem in organic semiconductor devices, can be decreased significantly only by a slight process change, and at the same time various electrode materials can be used.
It is therefore possible to apply the present invention widely to improve the performance of various organic semiconductor devices including organic transistors.

## Claims

1. A method of manufacturing a contact structure for organic semiconductor devices, comprising:
a process of forming an organic semiconductor layer; and
a process of forming a current-supply layer made of a conductive material,
wherein, a process of forming a charge-injection layer made of a thin film of an easily oxidizable metal, one face of which contacting the current-supply layer and the other face contacting the organic semiconductor layer, is provided between the process of forming the organic semiconductor layer and the process of forming the current-supply layer made of the conductive material.

2. A method of manufacturing a contact structure for organic semiconductor devices, comprising:
a process of forming a current-supply layer made of a conductive material; and
a process of forming an organic semiconductor layer,
wherein, a process of forming a charge-injection layer made of a thin film of an easily oxidizable metal, one face of which contacting the current-supply layer and the other face contacting the organic semiconductor layer, is provided between the process of forming the current-supply layer made of the conductive material and the process of forming the organic semiconductor layer.

3. The method of manufacturing a contact structure for organic semiconductor devices as set forth in claim 1 or 2, wherein the thin film of the easily oxidizable metal is oxidized by surrounding oxygen to be changed into a native oxide film.

4. The method of manufacturing a contact structure for organic semiconductors as set forth in claim 3, wherein the surrounding oxygen is supplied by exposing the metal thin film to the air after completion of all the processes, or by exposing the metal thin film to the air when taking it out from a treatment vessel during the device manufacturing after the process of forming the charge-injection layer but before completion of all the processes.

5. The method of manufacturing a contact structure for organic semiconductor devices as set forth in one of claims 1 to 4, wherein a conducting material used as the current-supply layer is any one of metals, conductive metal oxides, and conductive organic materials.

6. The method of manufacturing a contact structure for organic semiconductor devices as set forth in one of claims 1 to 5, wherein the easily oxidizable metal has oxidation-reduction potential smaller than +0.5 V.

7. The method of manufacturing a contact structure for organic semiconductor devices as set forth in one of claims 1 to 6, wherein the thickness of the charge-injection layer is less than 5 nm.

8. The method of manufacturing a contact structure for organic semiconductor devices as set forth in one of claims 1 to 7, wherein the easily oxidizable metal is any one of beryllium (Be), nickel (Ni), aluminum (Al), chromium (Cr), cobalt (Co), zinc (Zn), copper (Cu), and iron (Fe).

9. The method of manufacturing a contact structure for organic semiconductor devices as set forth in one of claims 1 to 8, wherein the organic semiconductor layer is any one of π-conjugated aromatic compounds, chain compounds, organic pigments, and organic silicon compounds.

10. The method of manufacturing a contact structure for organic semiconductor devices as set forth in claim 9, wherein the organic semiconductor layer is any one of acene compounds including pentacene, perylene compounds, origothiophenes, polythiophenes, phthalocyanines including copper phthalocyanine, and porphyrins.

11. The method of manufacturing a contact structure for organic semiconductor devices as set forth in claims 1 to 10, wherein the organic semiconductor device is any one of organic transistors, organic light-emitting diodes, organic photovoltaic cells, and organic memories.

12. A contact structure for organic semiconductor devices, comprising (a) and (b) shown below:
(a) a conductive thin film, and
(b) a native oxide film of an easily oxidizable metal, one face of which contacting an organic semiconductor layer and the other face contacting the conductive thin film.

13. The contact structure for organic semiconductor devices as set forth in claim 12, wherein the easily oxidizable metal has oxidation-reduction potential lower than +0.5 V.

14. The contact structure of organic semiconductor devices as set forth in claim 12 or 13, wherein the thickness of the easily oxidizable metal is less than 5 nm.

15. The contact structure for organic semiconductor devices as set forth in one of claims 12 to 14, wherein the easily oxidizable metal is any one of beryllium (Be), nickel (Ni), aluminum (Al), chromium (Cr), cobalt (Co), zinc (Zn), copper (Cu), and iron (Fe).

16. The contact structure for organic semiconductor devices as set forth in one of claims 12 to 15, wherein the organic semiconductor layer is any one of π-conjugated aromatic compounds, chain compounds, organic pigments, and organic silicon compounds.

17. The contact structure for organic semiconductor devices as set forth in claim 16, wherein the organic semiconductor layer is any one of acene compounds including pentacene, perylene compounds, origothiophenes, polythiophenes, phthalocyanines including copper phthalocyanine, and porphyrins.

18. The contact structure for organic semiconductor devices as set forth in one of claims 12 to 17, wherein the conductive thin film is any one of metals, conductive metal oxides, and conductive organic substances.

19. The contact structure for organic semiconductor devices as set forth in one of claims 12 to 18, wherein the organic semiconductor device is any one of organic transistors, organic light-emitting diodes, organic photovoltaic cells, and organic memories.
